# EUROPEAN PATENT SPECIFICATION

(11) **EP 1 860 929 B1**
(45) Date of publication and mention of the grant of the patent: **11.02.2009**
(21) Application number: 06252677.7
(22) Date of filing: 23.05.2006
(51) Int. Cl.: H05K 9/00

(54) **Mobile wireless communications device having an absorber for reducing energy radiated from an RF component**
Mobiles drahtloses Kommunikationsgerät mit einem Absorber zur Verminderung der aus einem RF Bauteil gestrahlten Energie
Dispositif de communications sans fil mobile avec un absorbeur réduisant l'énergie rayonnée par un composant haute fréquence

(43) Date of publication of application: 28.11.2007
(73) Proprietor: Research In Motion Limited, Waterloo, Ontario N2L 3W8 (CA)
(72) Inventor: Zhu, Lizhong, Waterloo, Ontario N2T 2T8 (CA); Corrigan, Michael, Waterloo, Ontario N2T 1S5 (CA); Grant, Robert, Littowel, Ontario N4W 3G8 (CA); George, Liviu, Mississauga, Ontario L5N 6R5 (CA); Jarmuszewski, Perry, Waterloo, Ontario N2V 2R6 (CA)
(74) Representative: Hibbert, Juliet Jane Grace

(56) References cited:
- WO-A-01/91530
- JP-A- 2005 286 191
- US-A1- 2002 029 893
- US-A1- 2004 146 452

## Description

### Field of the Invention

The present invention relates to the field of communications devices, and more particularly, to mobile wireless communications devices and related methods.

### Background of the Invention

Cellular communication systems continue to grow in popularity and have become an integral part of both personal and business communications. Cellular telephones allow users to place and receive phone calls most anywhere they travel. Moreover, as cellular telephone technology is increased, so too has the functionality of cellular devices. For example, many cellular devices now incorporate Personal Digital Assistant (PDA) features such as calendars, address books, task lists, calculators, memo and writing programs, etc. These multi-function devices usually allow users to wirelessly send and receive electronic mail (email) messages and access the internet via a cellular network and/or a wireless local area network (WLAN), for example.

As the functionality of cellular communications devices continues to increase, so too does demand for smaller devices that are easier and more convenient for users to carry. As any circuit boards and electronic components thereon are reduced in size and placed closer together, including antenna and microphone components, various electronic components can pick up conductive energy and create interference within the system.

Many of the designs include an RF metal shield secured onto the printed circuit board, and surrounding and isolating different RF components, including transceiver chip sets such as multi-chip modules, which are secured on the circuit board within the housing. The RF metal shield encloses these components and chip sets. Some of the RF components or chip sets radiate RF energy to other chips or components that are in close proximity from electromagnetic coupling through the RF metal shield. This type of electromagnetic coupling (EMC) or electromagnetic interference (EMI) coupling causes interference to the RF circuits, and degrades RF performance, such as receiver sensitivity. Thus, the RF metal shield that is supposed to shield the components from extraneous RF energy can in and of itself create electromagnetic coupling problems with different RF components that are supposed to be shielded within the RF shield.

US2002/0029893 (Toyoda) discloses an electromagnetic wave shielding apparatus for shielding electromagnetic waves generated from a circuit so as to prevent the electromagnetic waves from being leaked to the outside of the circuit. The apparatus includes a metal member disposed in such a manner as to be opposed to the circuit, and an electromagnetic wave absorbing member disposed on the metal member, wherein the electromagnetic absorbing member is composed of a carbon layer and coil-like carbon fiber structures. The apparatus is allowed to simply obtain an electromagnetic wave absorbing function without increasing the weight of the apparatus.

### Summary of the Invention

A mobile wireless communications device includes a housing and circuit board carried by the housing and having RF circuitry comprising at least one RF component, and a plurality of other components mounted on the circuit board. An RF metal shield is secured to the circuit board and surrounds and isolates the at least one RF component and plurality of other components within the RF metal shield. An RF absorber is positioned adjacent an area of the RF component that radiates energy to aid in reducing any energy radiated from the RF component into the RF metal shield. As a result, the electromagnetic coupling or interference with other portions of the RF component or other components within the RF metal shield is reduced.

The RF shield, in one non-limiting example, has an opening at an area of the RF component that radiates energy. The RF absorber is formed as an RF absorbing material positioned at the opening of the RF metal shield. This RF absorbing material could be formed as a ferrite material, and preferably as a planar sheet that could be secured by adhesive tape to the RF metal shield. The RF absorber could also be formed as a longitudinal slot positioned over the area of the RF component that radiates RF energy.

In another non-limiting example, the RF component can be formed as an RF chip set and preferably as a transceiver chip set that could be formed as a transmitter chip, receiver chip and local oscillator chip. The RF absorber can be positioned adjacent the transmitter chip. The RF circuitry could also be operative for generating Global System for Mobile (GSM) communications packet bursts. The RF circuitry could also include an RF transceiver, multi-chip module and associated RF components.

A method aspect is also set forth.

### Brief Description of the Drawings

Other objects, features and advantages will become apparent from the detailed description which follows when considered in light of the accompanying drawings in which:

FIG. 1 is a schematic block diagram of an example of a mobile wireless communications device configured as a handheld device that can be used and illustrating basic internal components thereof.

FIG. 2 is a front elevation view of the mobile wireless communications device of FIG. 1.

FIG. 3 is a schematic block diagram showing basic functional circuit components that can be used in the mobile wireless communications device of FIGS. 1-2.

FIG. 4 is front elevational view of the mobile wireless communications device having the front cover removed to illustrate an example of RF circuitry, power amplifier, surface mounted microphone and noise isolation components associated thereof.

FIG. 5 is a fragmentary, isometric drawing of a prior art RF metal shield covering an RF transceiver on a printed circuit board.

FIG. 6 is a fragmentary, isometric drawing of an RF metal shield that includes an RF absorber formed as absorbing material positioned at an opening of the RF metal shield to aid in reducing RF energy radiated from an RF component such as part of an RF transceiver chip set into the RF metal shield and causing electromagnetic coupling or electromagnetic interference with other portions of the RF components or chip set within the RF metal shield.

FIG. 7 is a fragmentary side elevation drawing of the RF metal shield and RF absorbing material positioned at an opening within the RF metal shield and covering a portion of an RF transceiver multi-chip module.

FIG. 8 is another embodiment showing the RF metal shield and the RF absorber formed as a long and narrow slot on the RF metal shield to reduce RF coupling.

### Detailed Description of the Preferred Embodiments

Different embodiments will now be described more fully hereinafter with reference to the accompanying drawings, in which preferred embodiments are shown. Many different forms can be set forth and described embodiments should not be construed as limited to the embodiments set forth herein. Rather, these embodiments are provided so that this disclosure will be thorough and complete, and will fully convey the scope to those skilled in the art. Like numbers refer to like elements throughout.

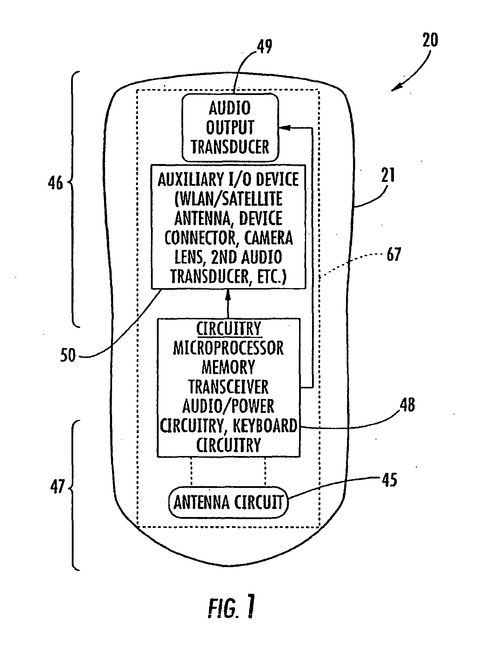

A brief description will now proceed relative to FIGS. 1-3, which disclose an example of a mobile wireless communications device, for example, a handheld portable cellular radio, which can incorporate the non-limiting examples of the various circuits. FIGS. 1-3 are representative non-limiting examples of the many different types of functional circuit components and their interconnection.

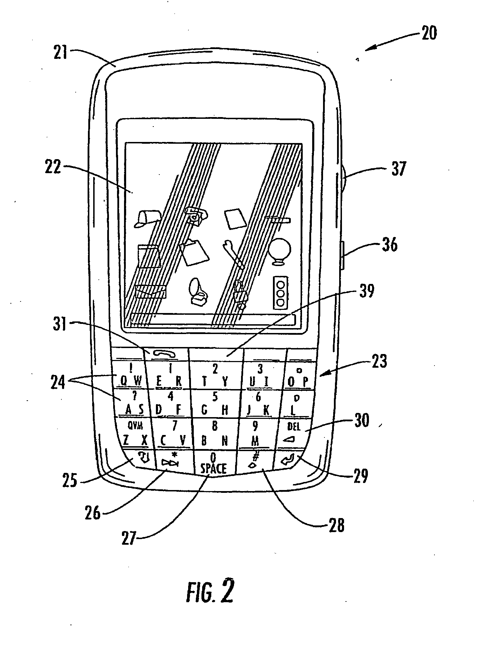

Referring initially to FIGS. 1 and 2, an example of a mobile wireless communications device **20,** such as a handheld portable cellular radio is first described. This device **20** illustratively includes a housing **21** having an upper portion **46** and a lower portion **47,** and a dielectric substrate (i.e., circuit board) **67,** such as a conventional printed circuit board (PCB) substrate, for example, carried by the housing. A housing cover (not shown in detail) would typically cover the front portion of the housing. The term circuit board **67** as used hereinafter can refer to any dielectric substrate, PCB, ceramic substrate or other circuit carrying structure for carrying signal circuits and electronic components within the mobile wireless communications device **20.** The illustrated housing **21** is a static housing, for example, as opposed to a flip or sliding housing which are used in many cellular telephones. However, these and other housing configurations may also be used.

Circuitry **48** is carried by the circuit board **67,** such as a microprocessor, memory, one or more wireless transceivers (e.g., cellular, WLAN, etc.), which includes RF circuitry, including audio and power circuitry, including any keyboard circuitry. It should be understood that keyboard circuitry could be on a separate keyboard, etc., as will be appreciated by those skilled in the art. A battery (not shown) is also preferably carried by the housing **21** for supplying power to the circuitry **48.** The term RF circuitry could encompass the interoperable RF transceiver circuitry, power circuitry and audio circuitry.

Furthermore, an audio output transducer **49** (e.g., a speaker) is carried by an upper portion **46** of the housing **21** and connected to the circuitry **48.** One or more user input interface devices, such as a keypad (keyboard) **23** (FIG. 2), is also preferably carried by the housing **21** and connected to the circuitry **48.** The term keypad as used herein also refers to the term keyboard, indicating the user input devices having lettered and/or numbered keys commonly known and other embodiments, including multi-top or predictive entry modes. Other examples of user input interface devices include a scroll wheel **37** and a back button **36.** Of course, it will be appreciated that other user input interface devices (e.g., a stylus or touch screen interface) may be used in other embodiments.

An antenna **45** is preferably positioned at the lower portion **47** in the housing and can be formed as a pattern of conductive traces that make an antenna circuit, which physically forms the antenna. It is connected to the circuitry **48** on the main circuit board **67.** In one non-limiting example, the antenna could be formed on an antenna circuit board section that extends from the circuit board at the lower portion of the housing. By placing the antenna **45** adjacent the lower portion **47** of the housing **21,** the distance is advantageously increased between the antenna and the user's head when the phone is in use to aid in complying with applicable SAR requirements. Also, a separate keyboard circuit board could be used.

More particularly, a user will typically hold the upper portion of the housing **21** very close to his head so that the audio output transducer **49** is directly next to his ear. Yet, the lower portion **47** of the housing **21** where an audio input transducer (i.e., microphone) is located need not be placed directly next to a user's mouth, and can be held away from the user's mouth. That is, holding the audio input transducer close to the user's mouth may not only be uncomfortable for the user, but it may also distort the user's voice in some circumstances. In addition, the placement of the antenna **45** adjacent the lower portion **47** of the housing **21** also advantageously spaces the antenna farther away from the user's brain.

Another important benefit of placing the antenna **45** adjacent the lower portion **47** of the housing **21** is that this may allow for less impact on antenna performance due to blockage by a user's hand. That is, users typically hold cellular phones toward the middle to upper portion of the phone housing, and are therefore more likely to put their hands over such an antenna than they are an antenna mounted adjacent the lower portion **47** of the housing **21.** Accordingly, more reliable performance may be achieved from placing the antenna **45** adjacent the lower portion **47** of the housing **21.**

Still another benefit of this configuration is that it provides more room for one or more auxiliary input/output (I/O) devices **50** to be carried at the upper portion **46** of the housing. Furthermore, by separating the antenna **45** from the auxiliary I/O device(s) **50,** this may allow for reduced interference therebetween.

Some examples of auxiliary I/O devices **50** include a WLAN (e.g., Bluetooth, IEEE 802.11) antenna for providing WLAN communication capabilities, and/or a satellite positioning system (e.g., GPS, Galileo, etc.) antenna for providing position location capabilities, as will be appreciated by those skilled in the art. Other examples of auxiliary I/O devices **50** include a second audio output transducer (e.g., a speaker for speaker phone operation), and a camera lens for providing digital camera capabilities, an electrical device connector (e.g., USB, headphone, secure digital (SD) or memory card, etc.).

It should be noted that the term "input/output" as used herein for the auxiliary I/O device(s) **50** means that such devices may have input and/or output capabilities, and they need not provide both in all embodiments. That is, devices such as camera lenses may only receive an optical input, for example, while a headphone jack may only provide an audio output.

The device **20** further illustratively includes a display **22,** for example, a liquid crystal display (LCD) carried by the housing **21** and connected to the circuitry **48.** A back button **36** and scroll wheel **37** can also be connected to the circuitry **48** for allowing a user to navigate menus, text, etc., as will be appreciated by those skilled in the art. The scroll wheel **37** may also be referred to as a "thumb wheel" or a "track wheel" in some instances. The keypad **23** illustratively includes a plurality of multi-symbol keys **24** each having indicia of a plurality of respective symbols thereon. The keypad **23** also illustratively includes an alternate function key **25,** a next key **26,** a space key **27,** a shift key **28,** a return (or enter) key **29,** and a backspace/delete key **30.**

The next key **26** is also used to enter a "*" symbol upon first pressing or actuating the alternate function key **25.** Similarly, the space key **27,** shift key **28** and backspace key **30** are used to enter a "0" and "#", respectively, upon first actuating the alternate function key **25.** The keypad **23** further illustratively includes a send key **31,** an end key **32,** and a convenience (i.e., menu) key **39** for use in placing cellular telephone calls, as will be appreciated by those skilled in the art.

Moreover, the symbols on each key **24** are arranged in top and bottom rows. The symbols in the bottom rows are entered when a user presses a key **24** without first pressing the alternate function key **25,** while the top row symbols are entered by first pressing the alternate function key. As seen in FIG. 2, the multi-symbol keys **24** are arranged in the first three rows on the keypad **23** below the send and end keys **31, 32.** Furthermore, the letter symbols on each of the keys **24** are arranged to define a QWERTY layout. That is, the letters on the keypad **23** are presented in a three-row format, with the letters of each row being in the same order and relative position as in a standard QWERTY keypad.

Each row of keys (including the fourth row of function keys **25-29)** is arranged in five columns. The multi-symbol keys **24** in the second, third, and fourth columns of the first, second, and third rows have numeric indicia thereon (i.e., 1 through 9) accessible by first actuating the alternate function key **25.** Coupled with the next, space, and shift keys **26, 27, 28,** which respectively enter a "*", "0", and "#" upon first actuating the alternate function key **25,** as noted above, this set of keys defines a standard telephone keypad layout, as would be found on a traditional touch-tone telephone, as will be appreciated by those skilled in the art.

Accordingly, the mobile wireless communications device **20** as described may advantageously be used not only as a traditional cellular phone, but it may also be conveniently used for sending and/or receiving data over a cellular or other network, such as Internet and email data, for example. Of course, other keypad configurations may also be used in other embodiments. Multi-tap or predictive entry modes may be used for typing e-mails, etc. as will be appreciated by those skilled in the art.

The antenna **45** is preferably formed as a multi-frequency band antenna, which provides enhanced transmission and reception characteristics over multiple operating frequencies. More particularly, the antenna **45** is designed to provide high gain, desired impedance matching, and meet applicable SAR requirements over a relatively wide bandwidth and multiple cellular frequency bands. By way of example, the antenna **45** preferably operates over five bands, namely a 850 MHz Global System for Mobile Communications (GSM) band, a 900 MHz GSM band, a DCS band, a PCS band, and a WCDMA band (i.e., up to about 2100 MHz), although it may be used for other bands/frequencies as well. To conserve space, the antenna **45** may advantageously be implemented in three dimensions although it may be implemented in two-dimensional or planar embodiments as well.

The mobile wireless communications device shown in FIGS. 1 and 2 can incorporate e-mail and messaging accounts and provide different functions such as composing e-mail, PIN messages, and SMS messages. The device can manage messages through an appropriate menu that can be retrieved by choosing a messages icon. An address book function could add contacts, allow management of an address book, set address book options and manage SIM card phone books. A phone menu could allow for the making and answering of phone calls using different phone features, managing phone call logs, setting phone options, and viewing phone information. A browser application could permit the browsing of web pages, configuring a browser, adding bookmarks, and changing browser options. Other applications could include a task, memo pad, calculator, alarm and games, as well as handheld options with various references.

A calendar icon can be chosen for entering a calendar program that can be used for establishing and managing events such as meetings or appointments. The calendar program could be any type of messaging or appointment/meeting program that allows an organizer to establish an event, for example, an appointment or meeting.

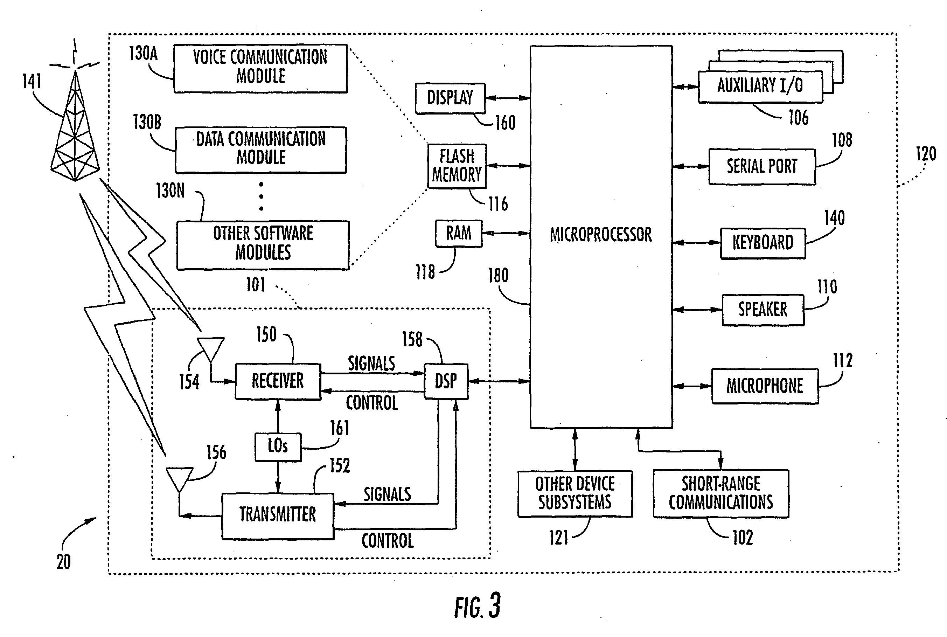

A non-limiting example of various functional components that can be used in the exemplary mobile wireless communications device **20** of FIGS. 1 and 2 is further described in the example below with reference to FIG. 3. The device **20** illustratively includes a housing **120,** a keypad **140** and an output device **160.** The output device **160** shown is preferably a display, which is preferably a full graphic LCD. Other types of output devices may alternatively be used. A processing device **180** is contained within the housing **120** and is coupled between the keypad **140** and the display **160.** The processing device **180** controls the operation of the display **160,** as well as the overall operation of the mobile device **20,** in response to actuation of keys on the keypad **140** by the user.

The housing **120** may be elongated vertically, or may take on other sizes and shapes (including clamshell housing structures). The keypad may include a mode selection key, or other hardware or software for switching between text entry and telephony entry.

In addition to the processing device **180,** other parts of the mobile device **20** are shown schematically in FIG. 3. These include a communications subsystem **101;** a short-range communications subsystem **102;** the keypad **140** and the display **160,** along with other input/output devices **106, 108, 110** and **112;** as well as memory devices **116, 118** and various other device subsystems **121.** The mobile device **20** is preferably a two-way RF communications device having voice and data communications capabilities. In addition, the mobile device **20** preferably has the capability to communicate with other computer systems via the Internet.

Operating system software executed by the processing device **180** is preferably stored in a persistent store, such as the flash memory **116,** but may be stored in other types of memory devices, such as a read only memory (ROM) or similar storage element. In addition, system software, specific device applications, or parts thereof, may be temporarily loaded into a volatile store, such as the random access memory (RAM) **118.** Communications signals received by the mobile device may also be stored in the RAM **118.**

The processing device **180,** in addition to its operating system functions, enables execution of software applications **130A-130N** on the device **20.** A predetermined set of applications that control basic device operations, such as data and voice communications **130A** and **130B,** may be installed on the device **20** during manufacture. In addition, a personal information manager (PIM) application may be installed during manufacture. The PIM is preferably capable of organizing and managing data items, such as e-mail, calendar events, voice mails, appointments, and task items. The PIM application is also preferably capable of sending and receiving data items via a wireless network **141.** Preferably, the PIM data items are seamlessly integrated, synchronized and updated via the wireless network **141** with the device user's corresponding data items stored or associated with a host computer system.

Communication functions, including data and voice communications, are performed through the communications subsystem **101,** and possibly through the short-range communications subsystem. The communications subsystem **101** includes a receiver **150,** a transmitter **152,** and one or more antennae **154** and **156.** In addition, the communications subsystem **101** also includes a processing module, such as a digital signal processor (DSP) **158,** and local oscillators (LOs) **161.** The specific design and implementation of the communications subsystem **101** is dependent upon the communications network in which the mobile device **20** is intended to operate. For example, the mobile device **20** may include a communications subsystem **101** designed to operate with the Mobitex^{™}, Data TAC^{™} or General Packet Radio Service (GPRS) mobile data communications networks, and also designed to operate with any of a variety of voice communications networks, such as AMPS, TDMA, CDMA, PCS, GSM, etc. Other types of data and voice networks, both separate and integrated, may also be utilized with the mobile device **20.**

Network access requirements vary depending upon the type of communication system. For example, in the Mobitex and DataTAC networks, mobile devices are registered on the network using a unique personal identification number or PIN associated with each device. In GPRS networks, however, network access is associated with a subscriber or user of a device. A GPRS device therefore requires a subscriber identity module, commonly referred to as a SIM card, in order to operate on a GPRS network.

When required network registration or activation procedures have been completed, the mobile device **20** may send and receive communications signals over the communication network **141.** Signals received from the communications network **141** by the antenna **154** are routed to the receiver **150,** which provides for signal amplification, frequency down conversion, filtering, channel selection, etc., and may also provide analog to digital conversion. Analog-to-digital conversion of the received signal allows the DSP **158** to perform more complex communications functions, such as demodulation and decoding. In a similar manner, signals to be transmitted to the network **141** are processed (e.g., modulated and encoded) by the DSP **158** and are then provided to the transmitter **152** for digital to analog conversion, frequency up conversion, filtering, amplification and transmission to the communication network **141** (or networks) via the antenna **156.**

In addition to processing communications signals, the DSP **158** provides for control of the receiver **150** and the transmitter **152.** For example, gains applied to communications signals in the receiver **150** and transmitter **152** may be adaptively controlled through automatic gain control algorithms implemented in the DSP **158.**

In a data communications mode, a received signal, such as a text message or web page download, is processed by the communications subsystem **101** and is input to the processing device **180.** The received signal is then further processed by the processing device **180** for an output to the display **160,** or alternatively to some other auxiliary I/O device **106.** A device user may also compose data items, such as e-mail messages, using the keypad **140** and/or some other auxiliary I/O device **106,** such as a touchpad, a rocker switch, a thumb-wheel, or some other type of input device. The composed data items may then be transmitted over the communications network **141** via the communications subsystem **101.**

In a voice communications mode, overall operation of the device is substantially similar to the data communications mode, except that received signals are output to a speaker **110,** and signals for transmission are generated by a microphone **112.** Alternative voice or audio I/O subsystems, such as a voice message recording subsystem, may also be implemented on the device **20.** In addition, the display **160** may also be utilized in voice communications mode, for example to display the identity of a calling party, the duration of a voice call, or other voice call related information.

Any short-range communications subsystem enables communication between the mobile device **20** and other proximate systems or devices, which need not necessarily be similar devices. For example, the short-range communications subsystem may include an infrared device and associated circuits and components, or a Bluetooth^{™} communications module to provide for communication with similarly-enabled systems and devices.

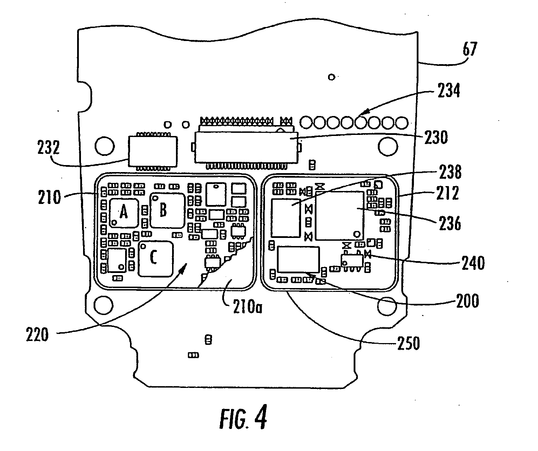

FIG. 4 is an example of a circuit layout on part of the circuit board **67** that can be included within the mobile wireless communications device **20** of FIGS. 1-3, and showing a front cover removed from a housing to illustrate a surface mounted microphone **200** and its circuitry and associated noise isolation components as will be explained in greater detail below. The circuit board **67** includes radio frequency (RF) circuitry, for example, cellular telephone communications circuitry, which is mounted in first and second isolation RF metal shields or "cans" **210,212,** as often called by those skilled in the art, forming a compartment on the circuit board, each which receive the RF circuitry and other components, which typically are RF components. Each can **210,212** forms a radio frequency isolation compartment and typically includes sides and a top, such as a portion of the top **210a** shown remaining on can **210.** The first can **210** includes a transceiver chip set **220,** for example, a transmitter chip, receiver chip, and local oscillator chip as non-limiting examples with those chips labeled A, B and C. The chip set could, in non-limiting examples, be formed as an RF transceiver multi-chip module. Other illustrated components could include the various resistors, capacitors, amplifiers, regulators and other circuit components common to those devices, but not explained in detail.

Located outside first and second isolation cans **210,212,** but mounted on the circuit board **67,** is a liquid crystal display (LCD) connector **230** and a keyboard connector **232,** as well as associated circuit components **234.** These components **230, 232** and **234** can be configured in different configurations besides the configuration illustrated in the non-limiting example of FIG. 4. The compartment within the second isolation can **212** includes a power amplifier **236** and switch diplexer **238.** Other components **240** are mounted within the compartment and form the resistors, capacitors, transistors, and inductors necessary to drive the audio and power circuits for the microphone, power amplifier and other circuits.

To provide microphone isolation, a radio frequency isolation shield **250,** formed in the illustrated non-limiting example as a third isolation "can" **250,** is positioned at a corner of the second "can" **212,** and forms another isolation compartment at this corner. The shield is formed as a separate metallic housing secured to the circuit board and surrounding the microphone, effectively covering, i.e., shielding the entire microphone. Although a "can" configuration formed as a metallic housing with top and sides and is used for the RF shield, other configurations could be used. The compartment formed by the isolation shield **250** receives a microphone **200** formed preferably as a surface mounted microphone integrated circuit chip **200** on the circuit board **67.** As illustrated in this non-limiting configuration, this places the microphone chip adjacent to the bottom center of the device **20** where the sound hole is typically located in the cover of a cellular phone or similar mobile wireless communications device.

To reduce noise resulting from RF circuitry, the metal RF shield or "can" forming an isolation shield includes a side and top metal wall, i.e., forming a complete isolation shield surrounding or covering the microphone 200 and its associated circuitry to provide isolation from the RF circuitry. This isolation shield provides the necessary isolation from the RF amplifiers and from any energy radiated from the antenna.

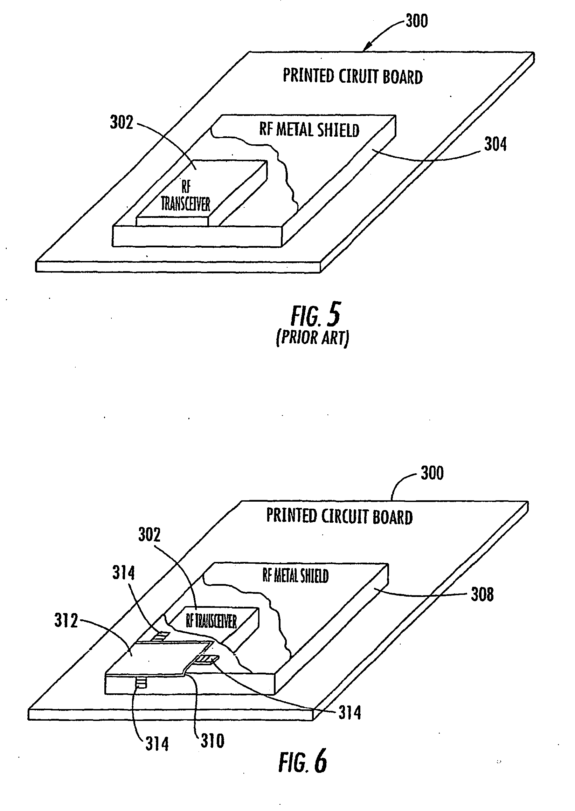

Referring now to FIGS. 5, a circuit board **300,** such as the type explained relative to FIGS. 1-4, is shown and includes an RF transceiver **302** mounted thereon, which could correspond to an RF transceiver multi-chip module as explained before, and having transmitter, receiver and local oscillator chips as explained before. The RF transceiver **302** is covered by an RF metal shield **304** as explained before. In this prior art example, the entire RF transceiver **302** is covered by the RF metal shield. In some instances, the RF energy from one portion of the RF transceiver or other RF component is generated into the RF metal shield and cause electromagnetic coupling or interference with certain sections of the RF transceiver or other RF components within the RF metal shield.

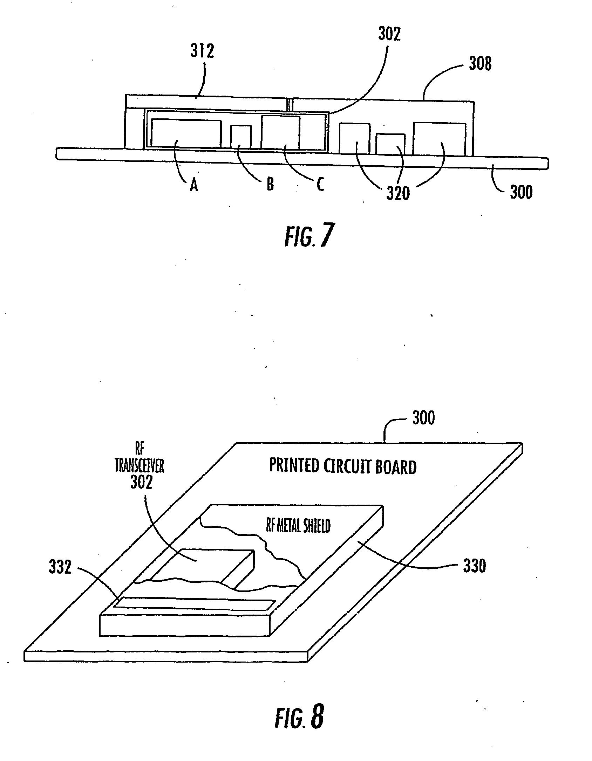

In accordance with one non-limiting example, the RF metal shield **308** shown in FIG. 6 has been modified to include an opening **310** positioned at that area or section of the RF transceiver or other RF component that radiates RF energy. An RF absorber **312** is formed as an RF absorbing material in this illustrated embodiment and positioned at the opening, i.e., adjacent that area of the RF component, such as the transceiver or chip that radiates RF energy, to aid in reducing RF energy radiated from the component into the RF metal shield and causing electromagnetic coupling or interference with other portions of the RF component or chip within the RF metal shield. This RF absorbing material **312** in the illustrated embodiment is formed as a ferrite material, preferably formed and as a planar sheet. Adhesive tape **314** can secure the RF absorbing material **312** to the RF metal shield. Of course, the RF transceiver is shown as one unit, such as an RF transceiver/multi-chip module, but it could include the basic transmitter chip, receiver chip and local oscillator chips labeled A, B and C as shown in FIG. 7, which are shown positioned in a multi-chip module and adjacent other RF and perhaps non-RF components **320** that are within the confines of the RF metal shield.

The RF absorbing material can be formed of different ferrite materials and typically has an applicable frequency of about 0.1 to about 3.0 GHz. An example of such RF absorbing material is the microwave absorbing material sold under the designation EA20/EA21 by Murata Manufacturing Company, Ltd. The thickness in non-limiting examples can range from about 0.05 millimeters to about 3.00 millimeters. The structure can be halogen free and have a flame resistance and operating temperature range from about -40 to about +120°C. Adhesive tape can be used to secure the material to an object, for example, the RF metal shield in this example. The material can be formed from an Ni-Zn ferrite material in one non-limiting example, and can have a specific gravity of about 3.4 (Typ) and a tensile strength of 3.0 MPa (min) and a surface resistance of about 1.0x10¹¹ (min), in non-limiting examples. Flame resistance can be compatible to UL94V-O.

FIG. 8 shows another RF metal shield **330** in which the RF absorber is formed as a longitudinally extending, but narrow slot **332** that is on the metal shield and positioned over that portion of the RF component that emits the RF radiation to prevent RF coupling as described before. In this specific instance, the longitudinal slot is operable to break-up the RF energy from coupling into the metal shield and onto other components, thus reducing the undesirable electromagnetic interference and electromagnetic coupling.

Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, and that modifications and embodiments are intended to be included within the scope of the appended claims.

## Claims

1. A mobile wireless communications device (20), comprising:
a housing (21);
a circuit board (300) carried by the housing (21) and having RF circuitry (48) comprising at least one RF component (302) and plurality of other components (320) mounted on said circuit board (300);
an RF metal shield (304) secured to said circuit board (300) and surrounding and isolating said at least one RF component (302) and plurality of other components (320) within said RF metal shield (304), said RF metal shield (304) having an opening (310) at an area of the RF component (302) that radiates energy, and an RF absorbing material (312) positioned at the opening (310) of the RF metal shield (304) to aid in reducing energy radiated from the RF component (302) into the RF metal shield (304) to reduce electromagnetic coupling or interference with other portions of said RF component (302) or other components (320) within said RF metal shield (304).

2. A mobile wireless communications device (20) according to Claim 1, wherein said RF absorbing material (312) comprises a ferrite material.

3. A mobile wireless communications device (20) according to Claim 2, wherein said RF absorbing material (312) comprises a planar sheet.

4. A mobile wireless communications device (20) according to Claim 3, and further comprising an adhesive tape securing to said RF metal shield (304) said planar sheet that forms said RF absorbing material (312).

5. A mobile wireless communications device (20) according to Claim 1, wherein said opening (310) is formed as a longitudinal slot (332) positioned over the area of the RF component that radiates energy.

6. A mobile wireless communications device (20) according to Claim 1, wherein said at least one RF component (302) comprises an RF chip set.

7. A mobile wireless communications device (20) according to Claim 6, wherein said RF chip set comprises a transceiver chip set.

8. A mobile wireless communications device (20) according to Claim 7, wherein said chip set comprises a transmitter chip, receiver chip and local oscillator chip.

9. A mobile wireless communications device (20) according to Claim 8, wherein said RF absorbing material (312) is positioned adjacent said transmitter chip.

10. A mobile wireless communications device (20) according to Claim 1, wherein said RF circuitry (48) is operative for generating Global System for Mobile (GSM) communications packet bursts.

11. A method for making a mobile wireless communications device (20), which comprises:
providing a housing (21), a circuit board (300) carried by the housing (21), radio frequency (RF) circuitry (48) including at least one RF component (302) and other components (320) carried by the circuit board (300), and a RF metal shield (304) secured to said circuit board (300) and surrounding and isolating said at least one RF component (302) and other components (320) within said RF metal shield (304); and
reducing energy radiated from a portion of an RF component (302) into the RF metal shield (304) to reduce the electromagnetic coupling or interference with other portions of said RF component (302) or other components (320) enclosed by said RF metal shield (304) by providing an opening (310) in the metal shield (304) at an area of the RF component (302) that radiates energy and positioning an RF absorbing material (312) at the opening (310) of the metal shield (304).

12. A method according to Claim 11, which further comprises forming the at least one RF component (302) as an RF chip set.

13. A method according to Claim 11, which further comprises forming the RF absorbing material (312) as a ferrite material.

## Patentansprüche

1. Mobile drahtlose Kommunikationsvorrichtung (20), die aufweist:
ein Gehäuse (21);
eine Leiterplatte (300), die durch das Gehäuse (21) getragen wird und HF-Schaltungen (48) hat, die zumindest eine HF-Komponente (302) und eine Vielzahl von anderen Komponenten (320) aufweisen, die auf der Leiterplatte (300) befestigt sind;
ein HF-Metall-Schild (304), das an der Leiterplatte (300) befestigt ist und das zumindest eine HF-Komponente (302) und eine Vielzahl von anderen Komponenten (320) in dem HF-Metall-Schild (304) umgibt und isoliert, wobei das HF-Metall-Schild (304) eine Öffnung (310) an einem Bereich der HF-Komponente (302) hat, der Energie ausstrahlt, und ein HF-Absorptionsmaterial (312), das an der Öffnung (310) des HF-Metall-Schilds (304) positioniert ist, um eine Reduzierung der Energie zu unterstützen, die von der HF-Komponente (302) in das HF-Metall-Schild (304) ausgestrahlt wird, um eine elektromagnetische Kopplung oder Interferenz mit anderen Teilen der HF-Komponente (302) oder anderen Komponenten (320) in dem HF-Metall-Schild (304) zu reduzieren.

2. Mobile drahtlose Kommunikationsvorrichtung (20) gemäß Anspruch 1, wobei das HF-Absorptionsmaterial (312) ein Ferrit-Material aufweist.

3. Mobile drahtlose Kommunikationsvorrichtung (20) gemäß Anspruch 2, wobei das HF-Absorptionsmaterial (312) eine planare Schicht aufweist.

4. Mobile drahtlose Kommunikationsvorrichtung (20) gemäß Anspruch 3, und weiter aufweisend ein Klebeband, das an dem HF-Metall-Schild (304) die planare Schicht befestigt, die das HF-Absorptionsmaterial (312) bildet.

5. Mobile drahtlose Kommunikationsvorrichtung (20) gemäß Anspruch 1, wobei die Öffnung (310) als ein Längsschlitz (332) ausgebildet ist, der positioniert ist über dem Bereich der HF-Komponente (302), der Energie ausstrahlt.

6. Mobile drahtlose Kommunikationsvorrichtung (20) gemäß Anspruch 1, wobei die zumindest eine HF-Komponente (302) einen HF-Chip-Satz aufweist.

7. Mobile drahtlose Kommunikationsvorrichtung (20) gemäß Anspruch 6, wobei der HF-Chip-Satz einen Transceiver-Chip-Satz aufweist.

8. Mobile drahtlose Kommunikationsvorrichtung (20) gemäß Anspruch 7, wobei der Chip-Satz einen Sender-Chip, einen Empfänger-Chip und einen lokalen Oszillator-Chip aufweist.

9. Mobile drahtlose Kommunikationsvorrichtung (20) gemäß Anspruch 8, wobei das HF-Absorptionsmaterial (312) angrenzend an den Sender-Chip positioniert ist.

10. Mobile drahtlose Kommunikationsvorrichtung (20) gemäß Anspruch 1, wobei die HF-Schaltungen (48) betriebsfähig sind zum Erzeugen von GSM(Global System for Mobile)-Kommunikationspaket-Bursts.

11. Verfahren zur Herstellung einer mobilen drahtlosen Kommunikationsvorrichtung (20), das aufweist:
Vorsehen eines Gehäuses (21), einer Leiterplatte (300), die durch das Gehäuse (21) getragen wird, Hochfrequenz(HF bzw. RF - radio frequency)-Schaltungen (48), einschließlich zumindest einer HF-Komponente (302) und anderer Komponenten (320), die durch die Leiterplatte (300) getragen werden, und eines HF-Metall-Schilds (304), das an der Leiterplatte (300) befestigt ist und die zumindest eine HF-Komponente (302) und andere Komponenten (320) in dem HF-Metall-Schild (304) umgibt und isoliert; und
Reduzieren von Energie, die von einem Teil einer HF-Komponente (302) in das HF-Metall-Schild (304) ausgestrahlt wird, um die elektromagnetische Kopplung oder Interferenz mit anderen Teilen der HF-Komponente (302) oder anderen Komponenten (320) zu reduzieren, die durch das HF-Metall-Schild (304) eingeschlossen sind, durch Vorsehen einer Öffnung (310) in dem HF-Metall-Schild (304) an einem Bereich der HF-Komponente (302), der Energie ausstrahlt, und Positionieren eines HF-Absorptionsmaterials (312) an der Öffnung (310) des HF-Metall-Schilds (304).

12. Verfahren gemäß Anspruch 11, das weiter aufweist ein Ausbilden der zumindest einen HF-Komponente (302) als einen HF-Chip-Satz.

13. Verfahren gemäß Anspruch 11, das weiter aufweist ein Ausbilden des HF-Absorptionsmaterials (312) als ein Ferrit-Material.

## Revendications

1. Dispositif mobile (20) de communications sans fil, comportant :
un boîtier (21) ;
une plaquette à circuit (300) portée par le boîtier (21) et ayant des circuits RF (48) comprenant au moins un composant RF (302) et plusieurs autres composants (320) montés sur ladite plaquette à circuit (300) ;
un blindage métallique RF (304) fixé à ladite plaquette à circuit (300) et entourant et isolant ledit au moins un composant RF (302) et plusieurs des autres composants (320) à l'intérieur dudit blindage métallique RF (304), ledit blindage métallique RF (304) ayant une ouverture (310) dans une zone du composant RF (302) qui rayonne de l'énergie, et une matière d'absorption RF (312) positionnée au niveau de l'ouverture (310) du blindage métallique RF (304) afin d'aider à réduire l'énergie rayonnée depuis le composant RF (302) vers l'intérieur du blindage métallique RF (304) afin de réduire le couplage ou l'interférence électromagnétique avec d'autres parties dudit composant RF (302) ou d'autres composants (320) à l'intérieur dudit blindage métallique RF (304).

2. Dispositif mobile (20) de communications sans fil selon la revendication 1, dans lequel ladite matière d'absorption RF (312) comprend une matière du type ferrite.

3. Dispositif mobile de communications sans fil (20) selon la revendication 2, dans lequel ladite matière d'absorption RF (312) comprend une feuille plane.

4. Dispositif mobile (20) de communications sans fil selon la revendication 3, comportant en outre un ruban adhésif fixant ledit blindage métallique RF (304) à ladite feuille plane qui forme ladite matière d'absorption RF (312).

5. Dispositif mobile (20) de communications sans fil selon la revendication 1, dans lequel ladite ouverture (310) est réalisée sous la forme d'une fente longitudinale (332) positionnée au-dessus de la zone du composant RF (302) qui rayonne de l'énergie.

6. Dispositif mobile (20) de communication sans fil selon la revendication 1, dans lequel ledit au moins un composant RF (302) comprend un ensemble à puce RF.

7. Dispositif mobile (20) de communications sans fil selon la revendication 6, dans lequel ledit ensemble à puce RF comprend un ensemble à puce d'émetteur-récepteur.

8. Dispositif mobile (20) de communications sans fil selon la revendication 7, dans lequel ledit ensemble à puce comprend une puce d'émetteur, une puce de récepteur et une puce d'oscillateur local.

9. Dispositif mobile (20) de communications sans fil selon la revendication 8, dans lequel ladite matière d'absorption RF (312) est positionnée de façon à être adjacente à ladite puce d'émetteur.

10. Dispositif mobile (20) de communications sans fil selon la revendication 1, dans lequel ledit circuit RF (48) fonctionne de façon à générer des salves de paquets de communication pour un système global pour mobile (GSM).

11. Procédé de réalisation d'un dispositif mobile (20) de communications sans fil, qui comprend :
l'utilisation d'un boîtier (21), d'une plaquette à circuit (300) portée par le boîtier (21), de circuits radiofréquence (RF) (48) comprenant au moins un composant RF (302) et d'autres composants (320) portés par la plaquette à circuit (300), et d'un blindage métallique RF (304) fixé à ladite plaquette à circuit (300) et entourant et isolant ledit au moins un composant RF (302) et d'autres composants (320) à l'intérieur dudit blindage métallique RF (304) ; et
la réduction de l'énergie rayonnée depuis une partie d'un composant RF (302) dans le blindage métallique RF (304) pour réduire le couplage ou l'interférence électromagnétique avec d'autres parties dudit composant RF (302) ou d'autres composants (320) entourés par ledit blindage métallique RF (304) du fait de la présence d'une ouverture (310) dans le blindage métallique (304) dans une zone du composant RF (302) qui rayonne de l'énergie et du positionnement d'une matière d'absorption RF (312) au niveau de l'ouverture (310) du blindage métallique (304).

12. Procédé selon la revendication 11, qui comprend en outre la formation du, au moins un, composant RF (302) sous la forme d'un ensemble à puce RF.

13. Procédé selon la revendication 11, qui comprend en outre la formation de la matière d'absorption RF (312) sous la forme d'une matière de type ferrite.
